# EUROPEAN PATENT SPECIFICATION

(11) **EP 4 560 048 B1**
(45) Date of publication and mention of the grant of the patent: **17.06.2026**
(21) Application number: 24214193.5
(22) Date of filing: 20.11.2024
(51) Int. Cl.: C23C 16/54, C23C 16/44, H10P 72/00

(54) **MULTI-CHAMBER ASSEMBLY FOR HANDLING REMOVABLE EPITAXIAL REACTION UNITS**
MEHRKAMMERANORDNUNG ZUR HANDHABUNG VON ENTFERNBAREN EPITAXIALREAKTIONSEINHEITEN
ENSEMBLE À CHAMBRES MULTIPLES POUR MANIPULER DES UNITÉS DE RÉACTION ÉPITAXIALE AMOVIBLES

(30) Priority: 21.11.2023 IT 202300024663; 30.04.2024 IT 202400009712
(43) Date of publication of application: 28.05.2025
(73) Proprietor: LPE S.p.A., 20021 Baranzate (MI) (IT)
(72) Inventor: Meschia, Maurilio, 20021 Baranzate (MI) (IT)
(74) Representative: Buzzi, Notaro & Antonielli d'Oulx S.p.A.

(56) References cited:
- US-A1- 2010 173 495
- US-A1- 2023 072 147

## Description

### FIELD OF INVENTION

The present invention relates to the field of preventive maintenance operations of removable reaction units for the deposition of semiconductor films on a substrate in epitaxial reactors.

The present invention further relates to the field of multi-chamber assemblies for the handling and conditioning of removable reaction units during preventive maintenance operations, in particular when said reaction units are used in reactors for the epitaxial deposition of semiconductor films on substrates.

The present invention further relates to multi-chamber assemblies for the handling and conditioning of both removable reaction units and substrate holders used in epitaxial reactors.

### BACKGROUND OF THE DISCLOSURE

The epitaxial growth equipment for the semiconductor industry may comprise a reactor containing a reaction and deposition chamber where the chemical vapor deposition process occurs. As a result of this process, several parts of the chamber will be subject to undesired product build-up and will require cleaning or substitution after several deposition cycles, to avoid affecting the quality and performance of the epitaxial deposition.

As a result, the consumable parts within the reaction chamber, as well as the walls and pieces composing the reaction chamber itself, necessitate preventive maintenance (PM) operations, which entail periodically accessing the chamber for the removal, cleaning, or substitution of said chamber as well as its concerned parts and pieces.

These operations heavily impact on the downtime of the reactor and its throughput. This issue is particularly felt in hot wall reactors for the deposition of SiC, where maintenance operations may occur up to one or more times a week, and cause interruptions that may last several hours.

In general, the removal, clean-up, and substitution of the concerned parts of a reaction chamber is a time-consuming process mostly carried out by hand.

Overall, the process requires a complete cooling and purge of the reactor, its undesired exposure to air, and the concurrent presence of one or more operators.

In the best-case scenario, where the reaction chamber is of the removable type, it is possible to pull out the reaction chamber from the reactor in its entirety via mechanical means. In this type of system, however, the reaction unit, i.e., the confined enclosed space (or working area) where the epitaxial deposition process takes place, cannot be easily decoupled from the bulky reaction chamber and is therefore for most purposes to be considered integral to the reaction chamber, since it cannot be individually handled and displaced.

For example, the reaction chamber described in EP 1570107 and US2022411961 is formed via the assembly of several elements which create an inner enclosure, hosting a working area that cannot be removed form the rest of the other susceptive elements on its own and in one piece.

The removal process of an entire reaction chamber as hereinbefore described presents several disadvantages: the access to the chamber is not automated or automatable, it requires the implementation of specific and time consuming EHS procedures, the reactor is exposed to air, and the displacement (and handling) of the reaction chamber is cumbersome and requires manual intervention.

It is also noted that in some last generation reactors, the handling of substrate holders is performed in an automated fashion and allows the substrate holders to be displaced from/to the reactor to/from a third chamber, apt to condition the substrates before entering the chamber and allowing to minimize their exposure to air.

US 2023/072147 Al discloses an equipment front end module (EFEM), a wafer transfer chamber, a wafer processing chamber, and a wafer transfer arm. The wafer processing chamber is a fixed element of the equipment.

US 2010/173495 Al discloses a wafer processing apparatus including an equipment front end module (EFEM), a wafer transfer chamber, a wafer processing chamber, and a wafer transfer arm. In addition, the EFEM may include an atmosphere control chamber configured to store a wafer carrier accommodating wafers. The wafer processing chamber is a fixed element of the equipment.

It is therefore desirable to devise a chamber assembly for the insertion and replacement processes of a reaction unit of a reaction chamber from the reactor to a suitable enclosed space for purging/conditioning operations, without exposing the reaction unit to air and speeding up PM operations.

It is furthermore desirable to provide an automated mechanical system configured to displace the reaction unit of a reaction chamber within the multi-chamber assembly to conduct specific handling, conditioning and/or purging operations, and reduce PM times. It is also desirable to provide a multi-chamber assembly adapted to cooperate, without interference, with the automated handling of a substrate holder, if present.

Finally, it is desirable to provide a reactor assembly integrated with the chamber assembly in a fully automated fashion, to further decrease PM downtimes, reduce EHS concerns, and offer a compact integrated solution.

### SUMMARY OF THE DISCLOSURE

It is an object of the present invention to overcome the disadvantages of the prior art. More specifically, it is an object of the present invention to provide a multi-chamber assembly for the handling of one or more removable reaction units of an epitaxial reactor for the deposition of a semiconductor film on a substrate and to preferably avoid its exposure to air.

It is a further object of the present invention to provide a multi-chamber assembly capable to execute the automated handling of both a removable reaction unit and a substrate holder.

It is an additional object of the present invention to provide a multi-chamber assembly adapted to be connected to a reactor suitable for the deposition of Si, SiC, and GaN films on semiconductor substrates having a reaction chamber equipped with a removable reaction unit.

It is a further object of the present invention to provide a multi-chamber assembly suitable to perform the automated handling of a reaction unit for preventive maintenance operations with reduced downtimes.

It is another object of the present invention to provide a reactor assembly integrated with the multi-chamber assembly, in order to handle a reaction unit and a substrate holder in fully automated fashion, while proving a compact, integrated solution.

The main objectives hereinbefore described are achieved through the invention recited in the appended claims, which constitute an integral part of the present description.

It is noted that the use of reference signs in the claims does not limit their scope. The sole purpose of reference signs is to make the claims easier to understand in reference to the drawings.

This summary is provided to introduce a selection of concepts in a simplified form. These concepts are further described in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE FIGURES

Fig. 1 provides a simplified sketch of a multi-chamber assembly according to an embodiment of the present invention.
Fig. 2 provides a simplified sketch of a multi-chamber assembly according to another embodiment of the present invention.
Fig. 3 provides a simplified sketch of a multi-chamber assembly according to another embodiment of the present invention.

It will be appreciated that elements in the figures are illustrated for simplicity and clarity and have not necessarily been drawn to scale. For example, the dimensions of some of the elements in the figures may have been omitted or, on the other hand, exaggerated relative to other elements to help improve understanding of illustrated embodiments of the present disclosure.

### DETAILED DESCRIPTION OF EXEMPLARY EMBODIMENTS

This application claims priority to IT App. 102024000009712, filed April 30, 2024.

This application also claims priority to IT App. 102023000024663, filed November 21, 2023.

Although certain embodiments and examples are disclosed below, it will be understood by those in the art that the invention extends beyond the specifically disclosed embodiments and/or uses of the invention. Thus, it is intended that the scope of the invention disclosed should not be limited by the particular disclosed embodiments described below.

Epitaxial reactors such as those used in SiC deposition often comprise a reaction chamber formed by one or more structural elements assembled together to create at least one enclosure, which defines at least one inner space, or working area, where the actual deposition takes place. See for instance EP 1570107 and US2022411961.

During PM operations, the reaction chambers like the ones described in the above non limiting example, provided solely for illustrative purpose, usually do not allow to remove and handle the specific enclosure where the deposition occurs. The bulky reaction chamber either needs to be extracted in one piece or internally accessed to remove the individual parts affected by undesired build up.

The applicant has devised an alternative reaction chamber design, where the reaction and deposition processes take place within an enclosed workplace, i.e., a reaction unit of a removable kind, which can be extracted in one piece from an essentially hollow casing and is adapted to cooperate with automated handling machines, optionally provided with specifically designed end effectors.

Such reaction unit is therefore a removable component of the reaction chamber of a reactor for the epitaxial deposition of semiconductor films on a substrate. It will be identified hereinafter as "removable reaction unit" or "reaction unit".

This novel design allows to extract and replace the reaction unit or its consumable parts in a simple manner, without having to reach its interiors from within the reactor machine or having to displace the entire, bulky, reaction chamber outside the reactor machine to access its internal parts and pieces, thus causing their undesired exposure to air.

The removable reaction unit of the reaction chamber may comprise engaging means, such as indentation, protrusions, hooks, loops, or slides, adapted to mechanically couple and cooperate with an end effector of a motorized mechanical system, or automated handling machine, in order to be handled in an automated fashion.

According to a first aspect, the present invention relates to a multi-chamber assembly for the handling of one or more removable reaction units of an epitaxial reactor for the deposition of a semiconductor film on a substrate.

The multi-chamber assembly comprises at least two chambers, a first chamber and a second chamber, as well as at least one transfer device setting the first chamber and the second chamber in communication with each other.

In particular, the first chamber, which can be also referred to as "transfer chamber", comprises at least one opening adapted to transfer the reaction unit from/to the reaction chamber of the reactor. The first chamber may advantageously be connected to the reactor, either directly or via an enclosed space.

The opening may be advantageously closable, sealable, and/or lockable, to allow isolating the first chamber from the reactor, in particular to prevent leakage of gases and/or to withstand a differential pressure between the two. For example, the aperture may be provided with a gate valve. The first chamber may be optionally connected to a system for vacuum generation and to a system for flowing and discharging gases.

The second chamber is designed for storing and/or handling one or more removable reaction units for PM and extraction. It can be also referred to as "unit handling chamber". It is provided with a resealable access suitable for the extraction and insertion of the reaction unit by an operator or by an automated system. After extraction, the removable reaction unit may be subject to routine PM operations, or it can be discarded at end of life.

The second chamber may be advantageously adapted to receive or discharge the removable reaction unit from/to the first chamber through a transfer device by means of a motorized mechanical system or a manually activate mechanical device.

Because of its storage capabilities, the second chamber allows to execute the replacement of a reaction unit for PM operations in a more efficient manner. The second chamber may be optionally conditioned, as will be discussed below, allowing to further prepare the reaction unit for PM or for entering the reactor for operation.

It can be inferred from the above that the term "chamber" indicates an enclosure surrounding a cavity and optionally provided with sealable apertures/openings.

The multi-chamber assembly described above allows to handle a removable reaction unit of an epitaxial reactor without exposing the latter to air. This allows to significantly reduce PM maintenance times.

Additionally, the multi-chamber assembly hereinbefore described may allow the automated handling of a reaction unit for preventive maintenance operations, thus positively impacting on the efficiency of the process.

It is understood that the reaction unit is a working area of the reactor suitable for the epitaxial deposition of a semiconductor film on a substrate. The substrate may be positioned on a substrate holder and lodged in a receiving area of the reaction unit. The substrate holder is a device that provides support to the substrate.

According to a preferred embodiment, the multi-chamber assembly according to the invention may include a motorized mechanical system comprising at least one inter-chamber actuator. The latter can be configured to grab and displace the removable reaction unit from the first chamber to the second chamber through the transfer device, and/or vice versa.

With the term "actuator" it is meant a part of a device or machine that allows it to achieve physical movements: it can be used to convert electrical, mechanical, gaseous, or hydraulic inputs into a linear or a rotatory movement, or to a sequential combination of both.

The above-described motorized mechanical system allows to move the reaction unit within the multi-chamber assembly without requiring the physical action or presence of an operator. Optionally, it can be remotely controlled with digital processing means, via cable or wireless, such as a computer.

In a non-limiting example, the motorized mechanical system may comprise a linear actuator provided with an end effector. The latter can be adapted to mechanically couple with the removable reaction unit to grab it and displace it, by moving from an extended position to a retreated position, and vice versa.

The end effector can be a gripper, such as: a rod, prong, fork, shovel, or combinations thereof.

To withstand the weight of the reaction unit, the end effector may be of a metallic or ceramic material, such as aluminum or silicon carbide (in oxide or nitride form), or titanium, stainless steel, and alloys thereof.

According to another embodiment, the transfer device comprises at least one transfer aperture, setting in communication the first chamber with the second chamber. It may further comprise one transfer gate valve adapted to open and close the transfer aperture. It is understood that the transfer aperture should be designed to allow the passage of the reaction unit alone and/or coupled to the motorized mechanical system, if present.

The first chamber and second chamber may be separated by a partition shared by both chambers, and the transfer aperture may be a through hole of suitable size formed on said partition.

Alternatively, the two chambers may not be integral with each other, but placed contiguous to each other (e.g., on top of each other, or side by side). **In** this case, the transfer aperture can be a through hole across two adjacent walls of the chambers, setting them in mutual direct communication.

**In** general, the first and second chamber may be placed one on top of the other, i.e., stacked in the vertical direction, regardless of the fact that they may be contiguous and/or integral to each other, or separated by other elements, as will be discussed below. This allows to reduce the footprint of the transfer device, and provides an advantageously compact solution.

According to a different embodiment, the transfer device comprises: (i) an interspace formed between the first chamber and second chamber; (ii) at least one first transfer aperture connecting the interspace with the first chamber; and (iii) at least one second transfer aperture connecting the interspace with the second chamber.

The term interspace hereby identifies and enclosed space separating the first chamber and the second chamber. **In** a non-limiting example, two walls of the enclosure may coincide with the walls of the first chamber and second chamber opposite to each other.

The first and second apertures face each other so that the removable reaction unit can be displaced between the first chamber and the second chamber passing though both the first and second aperture facing each other, and the portion of interspace between them.

The adjective "first" and "second" applied to the transfer apertures are meant to merely distinguish the apertures formed on the side facing the first chamber from the ones on the side facing the second chamber respectively, and do not imply any other limitation in their quantity, order, or position.

The transfer device additionally comprises at least one transfer gate valve adapted to seal the first and/or second transfer apertures.

Advantageously, each of the first apertures and each of the second apertures can be equipped with a gate valve, which are identified as first and second transfer gate valve respectively (thus depending on the side they are facing). The transfer device may comprise at least one automated double sealing system adapted to operate said first and said second transfer gate valves independently from each other.

This design prevents the second chamber and the first chamber from contaminating each other, especially if/when the two chambers are at a different pressure, and or are flushed with specific gaseous species. To this effect, it may be particularly advantageous to use a double valve system, comprising a first transfer gate valve and a second transfer gate valve individually closing/opening the first aperture and the second aperture, respectively.

According to an embodiment of the invention, the second chamber is provided with at least one shelf adapted to support one or more removable reaction units. The second chamber may further comprise a single-chamber automated system configured to displace at least one removable reaction unit within the second chamber, and optionally also through the resealable access. The resealable access connects the second chamber to the surrounding external area of the reactor. An operator may receive the reaction unit through the resealable access, to clean the unit or its consumable parts from parasitic deposits, or to dispose of the same.

The use of one or more shelves, preferably between 1 and 10, allows the second chamber to store multiple reaction units. For example, some shelves may be used to store reaction units due for PM, while others may store conditioned units, ready for use, to immediately replace the ones extracted for PM. To this effect, the shelves may be disposed at different heights depending on their purpose. Each shelf may store more than one reaction unit, preferably between 1 and 10.

The single-chamber automated system may comprise one or more actuators suitable to displace one or more reaction units within the second chamber to place it, or remove it, on/from the shelves. It may also allow to displace the reaction unit to/from each shelf and the outside of the multi-chamber assembly. Furthermore, these actuators may be advantageously adapted to collect the reaction unit form the motorized mechanical system when it enters the second chamber and position the reaction unit on a shelf.

In this way, the reaction unit may be transferred from a shelf of the second chamber to the first chamber, or vice versa. The first chamber may be also equipped with one or more shelves and can be provided with its own single-chamber automated systems, in analogy to the second chamber.

The actuators of the single-chamber automated system, regardless of the chamber where they are employed, may be optionally provided with end effectors suitable to mechanically couple with the reaction unit.

It is understood that each shelf and actuator may be integrated or integral to each other.

It is noted that the reaction unit may typically weight between 2 - 15 kg, preferably 2 - 10 kg, even more preferably 2,5 - 6 kg.

The reaction unit may exhibit an overall box-like shape with a rectangular cross section of 200 - 400 mm times 30 - 50 mm, and extending for 200 - 500 mm in a longitudinal direction.

The shelves shall be therefore configured to support a reaction unit having the size and weight described above.

Both the actuator of the single-chamber automated system and the inter-chamber actuator should be adapted to handle a reaction unit having the size and weight described above.

Both the actuator of the single-chamber automated system and the inter-chamber actuator may be designed to displace their targets in the horizonal plane (parallel to the floor supporting the transfer device) or in a vertical direction perpendicular to said horizontal plane, depending on the mutual arrangement of chambers and shelves.

Under an embodiment, the multi-chamber assembly according to the invention comprises a heating system configured to heat the second chamber to a temperature of 150-500 °C. For example, the heating system may be an electrical resistance heating system.

The multi-chamber assembly may additionally comprise at least one vacuum system configured to create a vacuum of less than 10 mbar in the second chamber. The vacuum system may be also configured to create a vacuum of less than 1 mbar in the second chamber, or more preferably below 10⁻³ mbar.

The second chamber may be further provided with at least one gas inlet and at least one gas outlet. The inlet and outlet allow flushing the second chamber and the reaction units stored therein with suitable gases, such as purge gases. The gas inlet and outlet should be each connected to a suitable gas circuit.

The optional equipment of the second chamber here discussed, such as the heating system, the vacuum system and/or the gas/inlet and outlets, may be advantageously used to condition the reaction unit.

With the term "condition" it is meant a variety of operations, or cycles, suitable to prepare a reaction unit, or a part/device, before insertion in the reactor. Additionally, or alternatively, the conditioning operations or cycles can be adapted to make the reaction unit suitable to be accessed by an operator or machine and extracted from the assembly for the safe removal or cleaning of parts.

For instance, before removal of the reaction unit, it is possible to create a vacuum of less than 10 mbar inside the second chamber and to perform a refilling under an inert gas such as argon, nitrogen, helium, or xenon. In addition, or in alternative to the inert gas refilling, the reaction unit may undergo an inert gas purge, the inert gas of preference being argon.

An alternative conditioning cycle suited to be performed on a new/clean reaction unit before insertion in the reactor may comprise the steps of heating the second chamber to a temperature of 150-500 °C and perform a vacuum degassing (the vacuum in this case should preferably be below 1 mbar, even more preferably below 10⁻³ mbar).

According to yet another embodiment, the multi-chamber assembly according to the invention further comprises a third chamber placed in communication with the first chamber through a substrate transfer aperture.

The third chamber is adapted to receive or discharge the substrate holder from/to the first chamber through the substrate transfer aperture via motorized or manual means.

The first chamber may optionally comprise a gate valve adapted to seal the substrate transfer aperture. It may further include one or more substrate holder shelves.

The first chamber may further comprise a substrate holder opening adapted to receive the substrate holder from the reaction unit in the reactor, or vice versa. It may be equipped with one or more shelves and automated means to suitably handle and store the substrate holders.

It is understood that the substrate holders are devices adapted to hold one or more semiconductor substrates on which the epitaxial film deposition takes place.

The first chamber, the second chamber, and the third chamber may each be connected to a same or different vacuum system.

In particular, the third chamber may be a load lock chamber. It can be connected to a heating and/or cooling system and may be adapted to condition the substrates before use or prior to extraction. It is understood that the third chamber can be further provided with openings, gate valves, and optional automated systems for the handling of the substrate holders or substrates, and for sealing the third chamber as appropriate. The handling may include any displacement starting or abutting into the first chamber or third chamber, and/or reaching the inside of the reactor, and/or the external surrounding area of the multi-chamber assembly open to air.

The substrate handling automated systems may be equipped with end effectors adapted to mechanically couple with the substrate holders. These can be advantageously made of silicon carbide, borosilicate glass, sapphire glass, or quartz to avoid contamination of the substrate.

The multi-chamber assembly comprising the third chamber allows to handle both a substrate holder and a removable reaction unit of a reaction chamber, thereby providing a unique compact solution that is space effective. **In** case automated systems are used, the solution according to the invention does not require the presence of an operator in situ and/or manual intervention.

It is understood that in the embodiment described above, the handling of the substrate holder and of the reaction unit should be mutually arranged so as not to interfere with each other.

Under a second aspect, the present invention relates to a reactor assembly for displacing and handling a reaction unit for preventive reactor maintenance operations.

The reactor assembly features, without limitation: (i) a reactor for the epitaxial deposition of a semiconductor film on a substrate, comprising a reaction chamber having a reaction unit removable in one piece from a susceptive casing; (ii) a multi-chamber assembly according to any of the embodiments hereinbefore described; and (iii) an automated handling machine for handling a removable reaction unit.

The automated handling machine is provided with a selective handling assembly comprising a first end effector and a second end effector, respectively engaging with the removable reaction unit and a substrate holder so as not to interfere with each other.

Specifically, the first end effector is configured to mechanically couple with the removable reaction unit to displace it along a longitudinal direction (x); whereas the second end effector is adapted to mechanically couple with a substrate holder to displace it along the longitudinal direction.

For example, the first and/or second end effector can be a gripper, such as: a rod, prong, fork, shovel, or combinations thereof.

To withstand the weight of the reaction unit, the first end effector may be of a metallic or ceramic material, such as aluminum or silicon carbide, in oxide or nitride form, or titanium, stainless steel, and alloys thereof. The second end effector can be made of silicon carbide, borosilicate glass, sapphire glass, or quartz to avoid contamination of the substrate.

Furthermore, the selective handling assembly comprises at least a first actuator adapted to displace the first and second end effector in a longitudinal direction from an extended position to a retreated position, and vice versa.

The first end effector is designed to withdraw, or insert, the removable reaction unit from, or into, the reactor. Advantageously, the first actuator can displace the reaction unit between the reaction chamber in the reactor and the multi-chamber assembly, preferably in correspondence to the first chamber, and even more preferably to the reaction unit opening.

The second end effector is adapted to withdraw, or insert, the substrate holder from, or into, the removable reaction unit, especially when the reaction unit is positioned within the reactor chamber inside the reactor.

The presence of a reactor assembly, integrating a multi-chamber assembly and an epitaxial reactor, prevents the exposure of the reaction unit to air during its extraction and insertion from/into the reactor, and the presence of automated handling means provides for a completely automated process that may reduce the downtime of the reactor of up to 70%.

The reactor may be suitable for the epitaxial deposition of a semiconductor film, preferably Si, SiC or GaN, on a substrate. **In** a non-limiting example, it may be a hot wall, crossflow reactor.

The reactor may advantageously comprise a thermal insulation system, featuring one or more thermally insulating components, forming an enclosure to the reaction chamber. It may also include a liner suitable to direct process gases in the reaction unit and connected thereto with releasable coupling means.

The reactor may be protected by an outer enclosure, such a double wall quartz tube, allowing a cooling fluid to flow in the interspace between its two walls. Other elements, which are typically used in reactors such as those hereinbefore described, can and should be present, as it may be apparent to a person with average skill in the art.

One or more induction coils may be located outside the reactor in order to heat the susceptive casing or the reaction chamber and hence, directly or indirectly, the reaction unit enclosed therein.

### DESCRIPTION OF FIGURES

The illustrations presented herein are not meant to be actual views of any particular material, structure, or device, but are merely idealized representations that are used to describe embodiments of the disclosure. Specifically, they are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

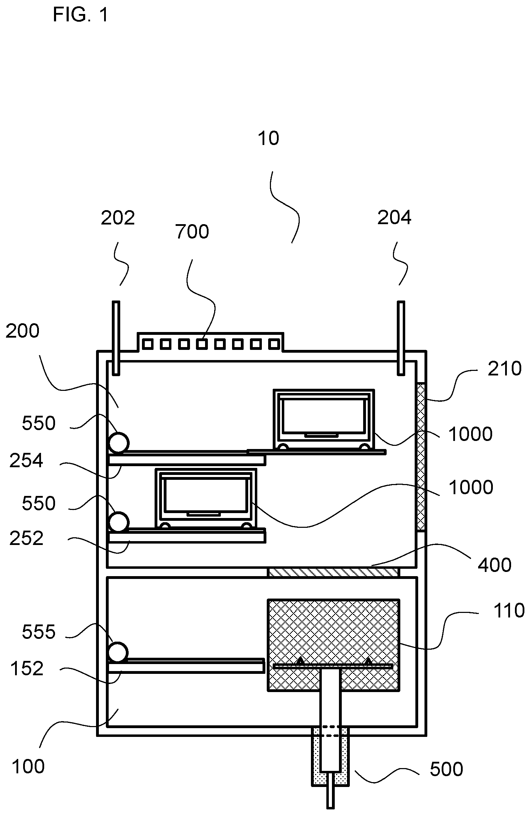

Fig. 1 schematically illustrates an open view of an embodiment of the multi-chamber assembly (10) according to the invention. The multi-chamber assembly is suitable for the handling and storage of the removable deposition units (1000). The units are designed to be extracted in one piece from an epitaxial reactor for the deposition of a semiconductor film on a substrate.

The multi-chamber assembly comprises a first chamber (100), a second chamber (200), and a transfer device (400).

The first chamber features an opening (110), identifiable as a "transfer unit opening", connected or connectable to the reactor. The opening may be equipped with a gate valve and is suited to receive/ discharge a reaction unit from/to the reaction chamber of the reactor.

Connected to the first chamber is the transfer device (400), which in this case is integrated within the first chamber, and specifically in one of its walls. In the present embodiment, the transfer device is an aperture that sets the first chamber in communication with the second chamber. This aperture, which allows the displacement of a reaction unit between the first chamber and the second chamber, is therefore identified as a "transfer aperture". It may be opened or closed with a gate valve (not shown), identified as a "transfer gate valve".

The second chamber (200) is designed to store and condition the reaction units. It includes a resealable access (210) suitable for the extraction and insertion of the reaction unit by an operator or by an automated system.

The multi-chamber assembly is equipped with a motorized mechanical system (500) comprising one inter-chamber actuator adapted to grab and displace the removable reaction unit from the first chamber to the second chamber, and/or vice versa, through the transfer device.

The second chamber is provided with two shelves (252, 254) capable to support a reaction unit. A single-chamber automated system (550) is configured to displace the reaction unit within the second chamber, and specifically to grab it from the motorized mechanical system and place it on a shelf, or vice versa. The single-chamber automated system is also designed to displace the reaction unit in and out of the resealable access (210). This access sets the second chamber in communication with the outside environment. It allows an operator to subsequently handle the reaction unit for cleaning or disposal.

The single-chamber automated system (550) comprises two actuators, each coupled to one shelf.

The second chamber is equipped with a resistive heating system (700) configured to heat the second chamber to a temperature of 150-500 °C. The second chamber also comprises an inlet (202) and outlet (204) for flowing selected gases. The second chamber is therefore suitable for conditioning of the reaction unit.

The first chamber is also equipped with one shelf (152) and a single-chamber automated system (555) configured to displace the reaction unit within the first chamber.

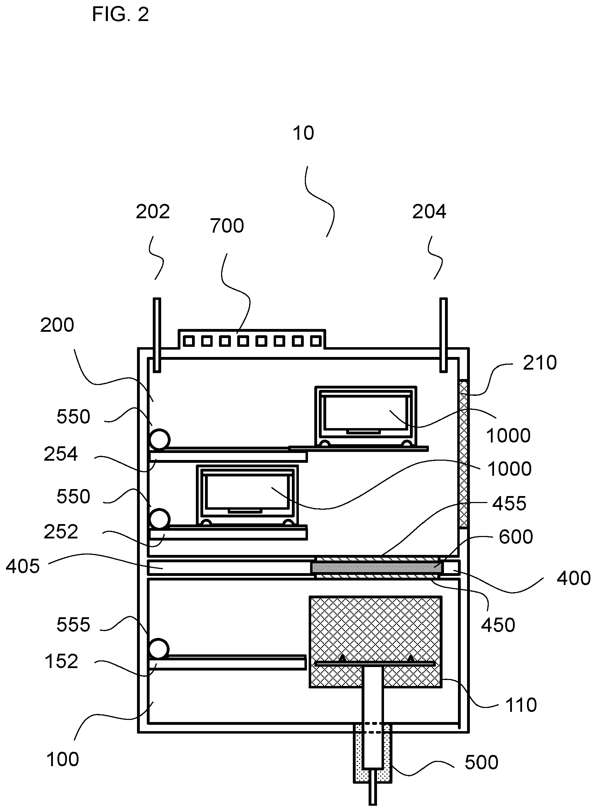

Fig. 2 schematically illustrates another embodiment of the multi-chamber assembly (10) according to the invention, adopting the same open view of Fig. 1, and using the same numerals for the same or equivalent functional features.

The present embodiment differs from the one described in Fig. 1 in that the transfer device (400) is an enclosure defining an interspace (405) placed between the first chamber and second chamber.

One "first transfer aperture" (450), i.e., an aperture opening towards the first chamber and suitable for transferring a reaction unit, connects the first chamber with the interspace.

One "second transfer aperture" (455), i.e., an aperture opening towards the second chamber and suitable for transferring a reaction unit, connects the interspace with the second chamber and faces directly the first transfer aperture. Since the first and second apertures face each other, it is possible to linearly displace the reaction unit through both apertures without difficulty.

The transfer device further comprises at least one transfer gate valve (600) adapted to seal the first and second transfer apertures. However, it is preferable to employ one gate valve per transfer aperture, and to operate them independently from each other.

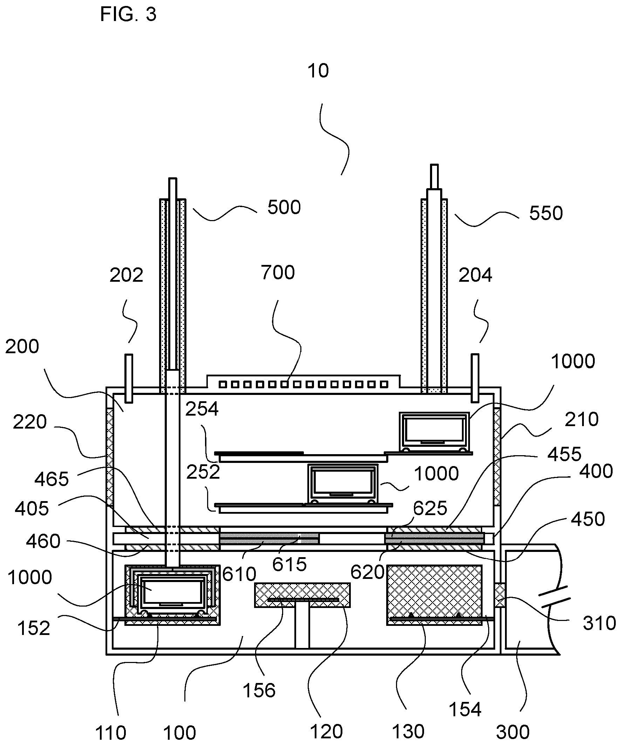

Fig. 3 schematically illustrates another embodiment of the multi-chamber assembly (10) according to the invention, adopting the same open view of Fig. 1 and Fig. 2, and using the same numerals for the same or equivalent functional features.

In the present embodiment, the multi-chamber assembly additionally comprises a third chamber (300) placed in communication with the first chamber (100) through a substrate transfer aperture (310), the latter being adapted to let through a substrate holder (and any automated means configured to displace said holder, if present).

The third chamber, here depicted only in part, is suitable for storing and optionally conditioning and/or cooling the substrates, before they enter the reactor, or after the deposition process.

Furthermore, the first chamber comprises two transfer unit openings (110, 130). These openings may be each equipped with a gate valve (not shown) and are suited to receive/ discharge a reaction unit from/to the reaction chamber of the reactor. They can be connected or connectable to the epitaxial reactor.

The first chamber comprises a substrate holder opening (120), which is adapted to displace a substrate holder between the multi-chamber assembly and the reactor, or an additional enclosed area connected or connectable thereto.

The first chamber also includes two shelves 8152, 154) for supporting a reaction unit. It comprises an additional shelf, a substrate holder shelf (156), which allows to lay the substrate holder before transferring it to the reactor or to the third chamber.

In the present embodiment, the motorized mechanical system (500) comprises two linear inter-chamber actuators.

As a consequence, the transfer device (400) comprises an interspace (405) placed between the first chamber and second chamber, and two "first transfer apertures" (450, 460), connecting the interspace with the first chamber. It also includes two "second transfer apertures" (455, 465), connecting the interspace with the second chamber. The "first transfer apertures" (450, 460) face the "second transfer apertures" (455, 465).

In this instance, each of the first aperture and the second aperture may be respectively equipped with one "first transfer gate valve" (610, 620) and one "second transfer gate valve" (615, 625) to individually seal each transfer aperture independently from one another. To this effect, it is convenient to implement at least one automated double sealing system adapted to operate these first and second transfer gate valves independently from each other.

In the description and the claims in this application the words "comprise" and its variations such as "comprising" and "comprises" do not rule out the presence of other additional elements, components, or stages.

The discussion of documents, deeds, materials, apparatus, articles and the like is included in the text solely for the purpose of providing context for this invention; it should not however be understood that this material or part thereof constitutes general knowledge in the field relating to the invention prior to the priority date of each of the claims appended to this application.

## Claims

1. A multi-chamber assembly (10) suitable for handling at least one reaction unit, wherein the multi-chamber assembly comprises:
- a first chamber (100) comprising at least one opening (110, 130) adapted to receive or discharge the reaction unit from/to the epitaxial reactor;
- a second chamber (200), for storing one or more reaction units, provided with a resealable access (210) suitable for the extraction and insertion of the reaction unit by an operator or by an automated system; and
- a transfer device (400) connecting the first chamber with the second chamber;
**characterized in that** the multi-chamber assembly further comprises a reaction unit (1000) comprising an enclosed workplace configured for carrying out a reaction and deposition process, the reaction unit being a removable component of a reaction chamber of a reactor suitable for the epitaxial deposition of a semiconductor film on a substrate.

2. The multi-chamber assembly according to any one of the preceding claims, further comprising a motorized mechanical system (500) comprising at least one inter-chamber actuator adapted to grab and displace the reaction unit from the first chamber to the second chamber, and/or vice versa, through the transfer device.

3. The multi-chamber assembly according to any one of the preceding claims, wherein the transfer device comprises at least one transfer aperture and at least one transfer gate valve adapted to open and close said at least one transfer aperture.

4. The multi-chamber assembly according to claim 1 or 2, wherein the transfer device comprises:
- an enclosed interspace (405) between the first chamber and second chamber; and
- at least one first transfer aperture (450, 460), connecting the interspace with the first chamber; and
- at least one second transfer aperture (455, 465), connecting the interspace with the second chamber and facing the at least one first transfer aperture; and
- at least one transfer gate valve (600) adapted to seal the first and/or second transfer apertures.

5. The multi-chamber assembly according to claim 4, wherein the at least one first aperture (450, 460) and the at least one second aperture (455, 465) are each equipped with a transfer gate valve (610, 620, 615, 625); the transfer device comprising at least one automated double sealing system adapted to operate each of said transfer gate valves independently from each other.

6. The multi-chamber assembly according to any one of the preceding claims, wherein the second chamber is provided with at least one shelf (252, 254) adapted to support at least one reaction unit; the second chamber further comprising a single-chamber automated system (550) configured to displace at least one reaction unit within the second chamber, and optionally through the resealable access.

7. The multi-chamber assembly according to any one of the preceding claims, further comprising a heating system (700) configured to heat the second chamber to a temperature of 150-500 °C.

8. The multi-chamber assembly according to claim 7, wherein the heating system is an electrical resistance heating system.

9. The multi-chamber assembly according to any one of the preceding claims, further comprising a vacuum system configured to create a vacuum of less than 10 mbar in the second chamber.

10. The multi-chamber assembly according to claim 9, wherein the vacuum system is configured to create a vacuum of less than 1 mbar, preferably less than 10⁻³ mbar.

11. The multi-chamber assembly according to any one of the preceding claims, wherein the second chamber is further provided with at least one gas inlet (202) and at least one gas outlet (204).

12. The multi-chamber assembly according to any one of the preceding claims, wherein the motorized mechanical system comprises a linear actuator provided with an end effector.

13. The multi-chamber assembly according to any one of the preceding claims, wherein:
- the first chamber comprises a substrate transfer aperture (310) adapted to transfer a substrate holder supporting a substrate; and
- the multi-chamber assembly further comprises a third chamber (300) placed in communication with the first chamber through the substrate transfer aperture; and
- the third chamber is adapted to receive or discharge the substrate holder from/to the first chamber through the substrate transfer aperture via motorized or manual means.

14. A reactor assembly for displacing and handling a reaction unit for preventive maintenance operations, wherein the reactor assembly comprises a reactor for the epitaxial deposition of a semiconductor film on a substrate, the reactor comprising a reaction chamber; and wherein the reactor assembly is **characterized in that** it further comprises:
- a multi-chamber assembly (10) according to any one of claims 1-13;
- an automated handling machine;
wherein the reaction chamber comprises a susceptive casing and a reaction unit removable in one piece from the susceptive casing, and
wherein the automated handling machine is suitable for handling the reaction unit.

15. The reactor according to claim 14, wherein the reactor extends along a longitudinal direction (x), and the automated handling machine is provided with a selective handling assembly comprising:
- a first end effector adapted to mechanically couple with the reaction unit to displace it along the longitudinal direction (x);
- a second end effector adapted to mechanically couple with a substrate holder to displace it along the longitudinal direction (x);
wherein the selective handling assembly comprises at least a first actuator adapted to displace the first and second end effector in the longitudinal direction from an extended position to a retreated position, and vice versa; the second end effector being adapted to withdraw, or insert, the substrate holder from, or into, the reaction unit; and the first end effector being adapted to withdraw, or insert, the reaction unit from, or into, the reactor.

## Patentansprüche

1. Eine Mehrkammer-Baugruppe (10), geeignet zur Handhabung mindestens einer Reaktionseinheit, wobei die Mehrkammer-Baugruppe umfasst:
- eine erste Kammer (100), umfassend mindestens eine Öffnung (110, 130), die ausgebildet ist, die Reaktionseinheit von dem Epitaxiereaktor aufzunehmen oder an diesen abzugeben;
- eine zweite Kammer (200) zum Lagern einer oder mehrerer Reaktionseinheiten, versehen mit einem wiederverschließbaren Zugang (210), der geeignet ist für die Entnahme und das Einlegen der Reaktionseinheit durch einen Bediener oder durch ein automatisiertes System; und
- eine Transfervorrichtung (400), die die erste Kammer mit der zweiten Kammer verbindet;
**dadurch gekennzeichnet, dass** die Mehrkammer-Baugruppe ferner eine Reaktionseinheit (1000) umfasst, die einen geschlossenen Arbeitsraum umfasst, der zur Durchführung eines Reaktions- und Abscheideprozesses konfiguriert ist, wobei die Reaktionseinheit eine entfernbare Komponente einer Reaktionskammer eines Reaktors ist, der für die epitaktische Abscheidung eines Halbleiterfilms auf einem Substrat geeignet ist.

2. Mehrkammer-Baugruppe nach einem der vorhergehenden Ansprüche, ferner umfassend ein motorisiertes mechanisches System (500), umfassend mindestens ein Zwischenkammer-Stellglied, das ausgebildet ist, die Reaktionseinheit von der ersten Kammer in die zweite Kammer und/oder umgekehrt durch die Transfervorrichtung zu greifen und zu verschieben.

3. Mehrkammer-Baugruppe nach einem der vorhergehenden Ansprüche, wobei die Transfervorrichtung mindestens eine Transferöffnung und mindestens ein Transfer-Schieberventil umfasst, das ausgebildet ist, die besagte mindestens eine Transferöffnung zu öffnen und zu schließen.

4. Mehrkammer-Baugruppe nach Anspruch 1 oder 2, wobei die Transfervorrichtung umfasst:
- einen geschlossenen Zwischenraum (405) zwischen der ersten Kammer und der zweiten Kammer; und
- mindestens eine erste Transferöffnung (450, 460), die den Zwischenraum mit der ersten Kammer verbindet; und
- mindestens eine zweite Transferöffnung (455, 465), die den Zwischenraum mit der zweiten Kammer verbindet und der mindestens einen ersten Transferöffnung gegenüberliegt; und
- mindestens ein Transfer-Schieberventil (600), das ausgebildet ist, die erste und/oder zweite Transferöffnung abzudichten.

5. Mehrkammer-Baugruppe nach Anspruch 4, wobei die mindestens eine erste Öffnung (450, 460) und die mindestens eine zweite Öffnung (455, 465) jeweils mit einem Transfer-Schieberventil (610, 620, 615, 625) ausgestattet sind; wobei die Transfervorrichtung mindestens ein automatisiertes Doppeldichtsystem umfasst, das ausgebildet ist, jedes der besagten Transfer-Schieberventile unabhängig voneinander zu betätigen.

6. Mehrkammer-Baugruppe nach einem der vorhergehenden Ansprüche, wobei die zweite Kammer mit mindestens einem Regal (252, 254) versehen ist, das ausgebildet ist, mindestens eine Reaktionseinheit zu tragen; wobei die zweite Kammer ferner ein Einzelkammer-Automatisierungssystem (550) umfasst, das konfiguriert ist, mindestens eine Reaktionseinheit innerhalb der zweiten Kammer und optional durch den wiederverschließbaren Zugang zu verschieben.

7. Mehrkammer-Baugruppe nach einem der vorhergehenden Ansprüche, ferner umfassend ein Heizsystem (700), das konfiguriert ist, die zweite Kammer auf eine Temperatur von 150-500 °C zu erhitzen.

8. Mehrkammer-Baugruppe nach Anspruch 7, wobei das Heizsystem ein elektrisches Widerstandsheizsystem ist.

9. Mehrkammer-Baugruppe nach einem der vorhergehenden Ansprüche, ferner umfassend ein Vakuumsystem, das konfiguriert ist, ein Vakuum von weniger als 10 mbar in der zweiten Kammer zu erzeugen.

10. Mehrkammer-Baugruppe nach Anspruch 9, wobei das Vakuumsystem konfiguriert ist, ein Vakuum von weniger als 1 mbar, vorzugsweise weniger als 10⁻³ mbar, zu erzeugen.

11. Mehrkammer-Baugruppe nach einem der vorhergehenden Ansprüche, wobei die zweite Kammer ferner mit mindestens einem Gaseinlass (202) und mindestens einem Gasauslass (204) versehen ist.

12. Mehrkammer-Baugruppe nach einem der vorhergehenden Ansprüche, wobei das motorisierte mechanische System einen Linearaktuator umfasst, der mit einem Endeffektor versehen ist.

13. Mehrkammer-Baugruppe nach einem der vorhergehenden Ansprüche, wobei:
- die erste Kammer eine Substrattransferöffnung (310) umfasst, die ausgebildet ist, einen ein Substrat tragenden Substrathalter zu transferieren; und
- die Mehrkammer-Baugruppe ferner eine dritte Kammer (300) umfasst, die durch die Substrattransferöffnung in Verbindung mit der ersten Kammer steht; und
- die dritte Kammer ausgebildet ist, den Substrathalter von der ersten Kammer durch die Substrattransferöffnung mittels motorisierter oder manueller Mittel aufzunehmen oder an diese abzugeben.

14. Eine Reaktorbaugruppe zum Verschieben und Handhaben einer Reaktionseinheit für vorbeugende Wartungsvorgänge, wobei die Reaktorbaugruppe einen Reaktor für die epitaktische Abscheidung eines Halbleiterfilms auf einem Substrat umfasst, wobei der Reaktor eine Reaktionskammer umfasst; und wobei die Reaktorbaugruppe **dadurch gekennzeichnet ist, dass** sie ferner umfasst:
- eine Mehrkammer-Baugruppe (10) nach einem der Ansprüche 1-13;
- eine automatisierte Handhabungsmaschine;
wobei die Reaktionskammer ein suszeptives Gehäuse und eine Reaktionseinheit umfasst, die in einem Stück aus dem suszeptiven Gehäuse entfernbar ist, und
wobei die automatisierte Handhabungsmaschine zur Handhabung der Reaktionseinheit geeignet ist.

15. Reaktor nach Anspruch 14, wobei sich der Reaktor entlang einer Längsrichtung (x) erstreckt und die automatisierte Handhabungsmaschine mit einer selektiven Handhabungsbaugruppe versehen ist, umfassend:
- einen ersten Endeffektor, der ausgebildet ist, mechanisch mit der Reaktionseinheit zu koppeln, um sie entlang der Längsrichtung (x) zu verschieben;
- einen zweiten Endeffektor, der ausgebildet ist, mechanisch mit einem Substrathalter zu koppeln, um ihn entlang der Längsrichtung (x) zu verschieben;
wobei die selektive Handhabungsbaugruppe mindestens ein erstes Stellglied umfasst, das ausgebildet ist, den ersten und zweiten Endeffektor in der Längsrichtung von einer ausgefahrenen Position in eine zurückgezogene Position und umgekehrt zu verschieben; wobei der zweite Endeffektor ausgebildet ist, den Substrathalter aus der Reaktionseinheit zurückzuziehen oder in diese einzuführen; und der erste Endeffektor ausgebildet ist, die Reaktionseinheit aus dem Reaktor zurückzuziehen oder in diesen einzuführen.

## Revendications

1. Ensemble multi-chambre (10) approprié pour manipuler au moins une unité de réaction, dans lequel l'ensemble multi-chambre comprend :
- une première chambre (100) comprenant au moins une ouverture (110, 130) adaptée pour recevoir ou décharger l'unité de réaction depuis/vers le réacteur épitaxial ;
- une deuxième chambre (200), pour stocker une ou plusieurs unités de réaction, pourvue d'un accès refermable (210) approprié pour l'extraction et l'insertion de l'unité de réaction par un opérateur ou par un système automatisé ; et
- un dispositif de transfert (400) reliant la première chambre à la deuxième chambre ;
**caractérisé en ce que** l'ensemble multi-chambre comprend en outre une unité de réaction (1000) comprenant un espace de travail fermé configuré pour réaliser un processus de réaction et de dépôt, ladite unité de réaction étant un composant amovible d'une chambre de réaction d'un réacteur approprié pour le dépôt épitaxial d'un film semi-conducteur sur un substrat.

2. Ensemble multi-chambre selon l'une quelconque des revendications précédentes, comprenant en outre un système mécanique motorisé (500) comprenant au moins un actionneur inter-chambres adapté pour saisir et déplacer l'unité de réaction de la première chambre à la deuxième chambre, et/ou vice versa, à travers le dispositif de transfert.

3. Ensemble multi-chambre selon l'une quelconque des revendications précédentes, dans lequel le dispositif de transfert comprend au moins une ouverture de transfert et au moins une vanne-porte de transfert adaptée pour ouvrir et fermer ladite au moins une ouverture de transfert.

4. Ensemble multi-chambre selon la revendication 1 ou 2, dans lequel le dispositif de transfert comprend :
- un espace intermédiaire fermé (405) entre la première chambre et la deuxième chambre ; et
- au moins une première ouverture de transfert (450, 460), reliant l'espace intermédiaire à la première chambre ; et
- au moins une deuxième ouverture de transfert (455, 465), reliant l'espace intermédiaire à la deuxième chambre et faisant face à ladite au moins une première ouverture de transfert ; et
- au moins une vanne-porte de transfert (600) adaptée pour sceller les première et/ou deuxième ouvertures de transfert.

5. Ensemble multi-chambre selon la revendication 4, dans lequel ladite au moins une première ouverture (450, 460) et ladite au moins une deuxième ouverture (455, 465) sont chacune équipées d'une vanne-porte de transfert (610, 620, 615, 625) ; le dispositif de transfert comprenant au moins un système de double étanchéité automatisé adapté pour actionner chacune desdites vannes-portes de transfert indépendamment les unes des autres.

6. Ensemble multi-chambre selon l'une quelconque des revendications précédentes, dans lequel la deuxième chambre est pourvue d'au moins une étagère (252, 254) adaptée pour supporter au moins une unité de réaction ; la deuxième chambre comprenant en outre un système automatisé à chambre unique (550) configuré pour déplacer au moins une unité de réaction à l'intérieur de la deuxième chambre, et optionnellement à travers l'accès refermable.

7. Ensemble multi-chambre selon l'une quelconque des revendications précédentes, comprenant en outre un système de chauffage (700) configuré pour chauffer la deuxième chambre à une température de 150-500 °C.

8. Ensemble multi-chambre selon la revendication 7, dans lequel le système de chauffage est un système de chauffage par résistance électrique.

9. Ensemble multi-chambre selon l'une quelconque des revendications précédentes, comprenant en outre un système de vide configuré pour créer un vide inférieur à 10 mbar dans la deuxième chambre.

10. Ensemble multi-chambre selon la revendication 9, dans lequel le système de vide est configuré pour créer un vide inférieur à 1 mbar, de préférence inférieur à 10⁻³ mbar.

11. Ensemble multi-chambre selon l'une quelconque des revendications précédentes, dans lequel la deuxième chambre est en outre pourvue d'au moins une entrée de gaz (202) et d'au moins une sortie de gaz (204).

12. Ensemble multi-chambre selon l'une quelconque des revendications précédentes, dans lequel le système mécanique motorisé comprend un actionneur linéaire pourvu d'un effecteur terminal.

13. Ensemble multi-chambre selon l'une quelconque des revendications précédentes, dans lequel :
- la première chambre comprend une ouverture de transfert de substrat (310) adaptée pour transférer un porte-substrat supportant un substrat ; et
- l'ensemble multi-chambre comprend en outre une troisième chambre (300) placée en communication avec la première chambre à travers l'ouverture de transfert de substrat ; et
- la troisième chambre est adaptée pour recevoir ou décharger le porte-substrat depuis/vers la première chambre à travers l'ouverture de transfert de substrat par des moyens motorisés ou manuels.

14. Ensemble réacteur pour déplacer et manipuler une unité de réaction pour des opérations de maintenance préventive, dans lequel l'ensemble réacteur comprend un réacteur pour le dépôt épitaxial d'un film semi-conducteur sur un substrat, le réacteur comprenant une chambre de réaction ; et dans lequel l'ensemble réacteur est **caractérisé en ce qu'**il comprend en outre :
- un ensemble multi-chambre (10) selon l'une quelconque des revendications 1 à 13 ;
- une machine de manipulation automatisée;
dans lequel la chambre de réaction comprend un boîtier de suscepteur et une unité de réaction amovible en une seule pièce du boîtier de suscepteur, et
dans lequel la machine de manipulation automatisée est appropriée pour manipuler l'unité de réaction.

15. Réacteur selon la revendication 14, dans lequel le réacteur s'étend le long d'une direction longitudinale (x), et la machine de manipulation automatisée est pourvue d'un ensemble de manipulation sélective comprenant :
- un premier effecteur terminal adapté pour se coupler mécaniquement avec l'unité de réaction pour la déplacer le long de la direction longitudinale (x) ;
- un deuxième effecteur terminal adapté pour se coupler mécaniquement avec un porte-substrat pour le déplacer le long de la direction longitudinale (x) ;
dans lequel l'ensemble de manipulation sélective comprend au moins un premier actionneur adapté pour déplacer les premier et deuxième effecteurs terminaux dans la direction longitudinale d'une position déployée à une position rétractée, et vice versa ; le deuxième effecteur terminal étant adapté pour retirer, ou insérer, le porte-substrat depuis, ou dans, l'unité de réaction ; et le premier effecteur terminal étant adapté pour retirer, ou insérer, l'unité de réaction depuis, ou dans, le réacteur.
